# EUROPÄISCHE PATENTSCHRIFT

(11) **EP 1 768 198 B1**
(45) Veröffentlichungstag und Bekanntmachung des Hinweises auf die Patenterteilung: **16.11.2011**
(21) Anmeldenummer: 06119295.1
(22) Anmeldetag: 22.08.2006
(51) Int. Cl.: H01L 41/083, H01L 41/047, F02M 51/06

(54) **Piezoelektrischer Aktor**
Piezoelectric actuator
Actionneur piézo-électrique

(30) Priorität: 27.09.2005 DE 102005046124
(43) Veröffentlichungstag der Anmeldung: 28.03.2007
(73) Patentinhaber: ROBERT BOSCH GMBH, 70442 Stuttgart (DE)
(72) Erfinder: Boecking, Friedrich, 70499 Stuttgart (DE)

(56) Entgegenhaltungen:
- WO-A2-03/073524
- DE-A1- 10 042 893
- DE-A1- 19 856 202

## Beschreibung

### Stand der Technik

Die Erfindung betrifft einen piezoelektrischen Aktor für ein Brennstoffeinspritzventil und ein Brennstoffeinspritzventil mit solch einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der DE 198 56 202 A1 ist ein piezoelektrischer Aktor bekannt. Der bekannte piezoelektrische Aktor dient insbesondere zur Betätigung von Einspritzventilen an Verbrennungsmotoren in Kraftfahrzeugen. Der bekannte Aktor weist einen piezoelektrischen Aktorkörper in Form eines vielschichtigen Laminats aus aufeinander geschichteten Lagen piezoelektrischen Materials und dazwischen liegenden metallischen beziehungsweise elektrisch leitenden, als Elektroden dienenden Schichten auf. Eine Elektrodenzuleitung zur Kontaktierung der als Elektroden dienenden Schichten ist seitlich an den Aktorkörper geführt und durch einen Elastomermantel oder Schrumpfschlauch vor direkter Luftfeuchte geschützt.

Der aus der DE 198 56 202 A1 bekannte Aktor hat den Nachteil, dass auf Grund der Elektrodenzuleitungen in Bezug auf die wirksame Fläche des Aktorkörpers ein relativ großer Aktorraum im Brennstoffeinspritzventil benötigt wird. Dadurch vergrößert sich auch die Baugröße des Brennstoffeinspritzventils. Sofern der Aktor einen quadratischen Querschnitt aufweist, besteht außerdem das Problem, dass der Elastomermantel oder der Schrumpfschlauch um die Kanten des Aktors geführt werden muss. Da die weitgehend aus dem keramischen Material der keramischen Schichten bestehenden Kanten relativ scharfkantig sind, kann es zumindest punktuell zur Beschädigung des Elastomermantels oder des Schrumpfschlauches kommen. Außerdem hat ein Elastomermantel oder ein Schrumpfschlauch nur einen begrenzten Krümmungsradius, so dass er im Bereich der Kanten nicht an dem Aktorkörper anliegt und ein unerwünschter Luftspalt ausgebildet ist. Auch wenn die Kanten angefast ausgestaltet sind, sind im Bereich der Fase an dem Aktorkörper Kanten ausgebildet, so dass die genannten Nachteile weiterhin bestehen.

In der Schrift DE 100 42 893 A1 ist ein laminiertes piezoelektrisches Stellglied mit an den Seitenoberflächen des Stellgliedkörpers ausgebildeten Außenelektroden offenbart. Der Stellgliedkörper ist durch Abschrägen von zwei gegenüberliegenden Seitenecken des quadratischen Körpers ausgebildet und die Außenelektroden sind an den Seitenoberflächen angeordnet.

### Vorteile der Erfindung

Der erfindungsgemäße piezoelektrische Aktor mit den Merkmalen des Anspruchs 1 hat demgegenüber den Vorteil, dass der für die Elektrodenanbindung benötigte Raumbedarf verbessert ist. Außerdem ist die aus piezokeramischem Material bestehende gesamte Kantenlänge des Aktors reduziert, das heißt, anstelle einer aus keramischem Material bestehenden Kante ist zumindest teilweise eine durch eine Elektrodenanbindung gebildete Kante vorgesehen. Die Zuverlässigkeit einer durch einen Elastomermantel oder einen Schrumpfschlauch oder dergleichen gebildeten Isolation kann dadurch verbessert werden.

Das erfindungsgemäße Brennstoffeinspritzventil mit den Merkmalen des Anspruchs 10 hat die entsprechenden Vorteile.

Durch die in den Unteransprüchen aufgeführten Maßnahmen sind vorteilhafte Weiterbildungen des im Anspruch 1 angegebenen piezoelektrischen Aktors und des im Anspruch 10 angegebenen Brennstoffeinspritzventils möglich.

Vorteilhaft ist es, dass die erste Elektrodenanbindung eine Kontaktschicht aufweist, die im Bereich der Kante des Aktors mit dem Aktorkörper und insbesondere mit dem ersten Teil der Elektrodenschichten zumindest abschnittsweise verbunden ist. Die Elektrodenschichten des ersten Teils der Elektrodenschichten erstrecken sich dabei zumindest teilweise bis zu der Aussparung des Aktorkörpers. Die Kontaktschicht ist erfindungsgemäß vor einem Sinterprozess und einem Entbinderungsprozess zur Herstellung des Aktors im Bereich der Kante des Aktors auf den Aktorkörper aufgedruckt und mit dem Aktorkörper anschließend durch Sintern verbunden. Dadurch kann eine zuverlässige mechanische Verbindung zwischen der Kontaktschicht der Elektrodenanbindung und dem Aktorkörper geschaffen werden, die eine zuverlässige elektrische Kontaktierung der ersten Elektrodenanbindung mit dem ersten Teil der Elektrodenschichten gewährleistet.

Vorzugsweise grenzt der erste Teil der Elektrodenschichten im Bereich der Kante des Aktors an die Aussparung des Aktorkörpers an, wobei ein zweiter Teil der Elektrodenschichten im Bereich der Kante des Aktors beabstandet zu der Aussparung ausgebildet ist. Die Elektrodenschichten des ersten Teils der Elektrodenschichten sind wechselweise mit den Elektrodenschichten des zweiten Teils der Elektrodenschichten zwischen den keramischen Schichten angeordnet, um jeweils die positiven und negativen Elektroden auszubilden. Diese Ausgestaltung hat den Vorteil, dass eine zuverlässige Kontaktierung mit nur dem ersten Teil der Elektrodenschichten im Rahmen eines einfachen Druckprozesses oder dergleichen bei der Herstellung des Aktors gewährleistet wird.

Vorteilhaft ist es, dass die erste Elektrodenanbindung ein Leitmittel aufweist, das mittels der Kontaktschicht mit dem ersten Teil der Elektrodenschichten verbunden ist, und dass das Leitmittel im Wesentlichen die Kante des Aktors, an der die Aussparung für die erste Elektrodenanbindung vorgesehen ist, ausbildet. Die Kante ist dadurch aus dem Material des Leitmittels gebildet, wobei im Bereich dieser Kante keine nach außen gerichteten Ecken oder scharfe Kanten aus piezokeramischem Material vorstehen. Dadurch wird zum einen ein Abbrechen oder Abbröseln von Teilen der piezokeramischen Schichten im Kantenbereich verhindert. Zum anderen wird in Kombination mit einem Isolationsmittel, insbesondere einer isolierenden Beschichtung, einem Elastomermantel oder einem Schrumpfschlauch, eine punktuelle Beschädigung, insbesondere ein Abreiben oder ein Einreißen, des Isolationsmittels verhindert. Das Leitmittel kann beispielsweise aus einem elektrisch leitenden Klebstoff gebildet sein, wodurch eine einfache Formgebung und eine relativ weiche Oberfläche im Bereich der Kante erreicht werden kann.

Es können auch zwei oder mehr solcher Elektrodenanbindungen vorgesehen sein, die in entsprechenden Aussparungen an Kanten des Aktors vorgesehen sind. Die verbleibenden Kanten oder Kantenabschnitte des Aktors, die zumindest teilweise aus dem piezokeramischen Material des Aktorkörpers bestehen, sind vorzugsweise als abgerundete Kanten ausgeführt.

### Zeichnung

Ein bevorzugtes Ausführungsbeispiel der Erfindung ist in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Brennstoffeinspritzventil mit einem piezoelektrischen Aktor in einer auszugsweisen, schematischen Schnittdarstellung gemäß einem Ausführungsbeispiel der Erfindung;
Fig. 2 einen auszugsweisen Schnitt durch den in Fig. 1 gezeigten Aktor des Brennstoffeinspritzventils entlang der mit II bezeichneten Schnittlinie und
Fig. 3 den in Fig. 2 mit III bezeichneten Ausschnitt in einer detaillierten Darstellung.

### Beschreibung des Ausführungsbeispiels

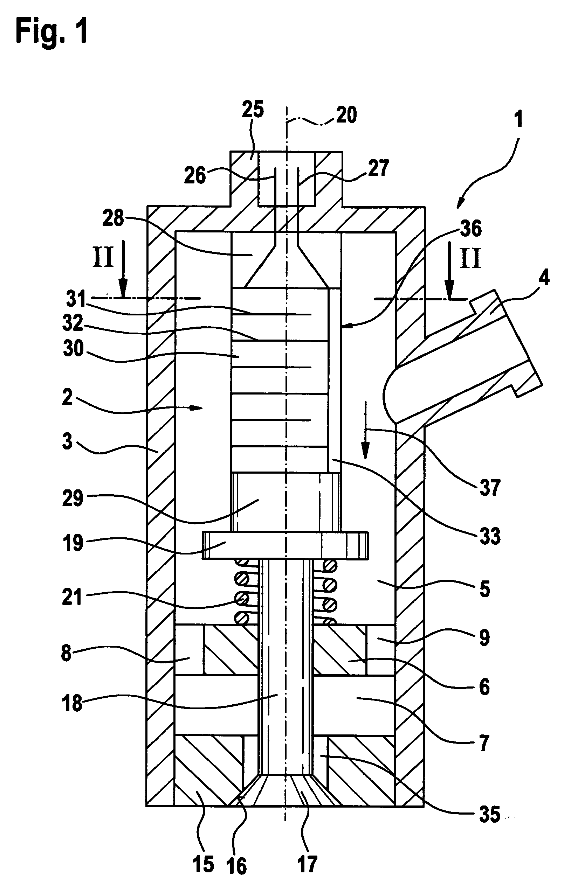

Fig. 1 zeigt ein Brennstoffeinspritzventil 1 mit einem piezoelektrischen Aktor 2 entsprechend einem Ausführungsbeispiel der Erfindung. Das Brennstoffeinspritzventil 1 kann insbesondere als Injektor für Brennstoffeinspritzanlagen von gemischverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße piezoelektrische Aktor 2 eignen sich jedoch auch für andere Anwendungsfälle.

Das Brennstoffeinspritzventil 1 weist ein Ventilgehäuse 3 und einen mit dem Ventilgehäuse 3 verbundenen Brennstoffeinlassstutzen 4 auf. An den Brennstoffeinlassstutzen 4 ist eine Brennstoffleitung anschließbar, um Brennstoff in einen im Inneren des Ventilgehäuses 3 vorgesehenen Aktorraum 5 einzuleiten. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind Durchlassöffnungen 8, 9 vorgesehen, um den zugeführten Brennstoff über den Aktorraum 5 in den Brennstoffraum 7 zu leiten.

Das Ventilgehäuse 3 ist mit einem Ventilsitzkörper 15 verbunden, an dem eine Ventilsitzfläche 16 ausgebildet ist. Die Ventilsitzfläche 16 wirkt mit einem Ventilschließkörper 17 zu einem Dichtsitz zusammen, wobei der Ventilschließkörper 17 einstückig mit einer Ventilnadel 18 ausgebildet ist. Über die Ventilnadel 18 ist der Ventilschließkörper 17 mit einer im Aktorraum 5 angeordneten Druckplatte 19 verbunden. Die Ventilnadel 18 wird dabei durch das Gehäuseteil 6 in Richtung einer Achse 20 des Brennstoffeinspritzventils 1 geführt. Die Ventilnadel 18 ist mittels der Druckplatte 19 durch eine Ventilfeder 21 mit einer Schließkraft beaufschlagt, so dass der zwischen dem Ventilschließkörper 17 und der Ventilsitzfläche 16 ausgebildete Dichtsitz in dem in der Fig. 1 dargestellten Ausgangsfall geschlossen ist.

An dem Ventilgehäuse 3 ist außerdem ein Anschlusselement 25 zum Anschließen einer elektrischen Zuleitung an das Brennstoffeinspritzventils 1 vorgesehen. Die elektrische Zuleitung kann dabei mittels eines Steckers an elektrische Leitungen 26, 27 angeschlossen werden, die durch das Gehäuse 3 und einen Aktorfuß 28 zu dem Aktor 2 geführt sind. Der Aktor 2 stützt sich dabei über den Aktorfuß 28 an der Innenseite des Ventilgehäuses 3 ab. Außerdem wirkt der Aktor 2 über einen Aktorkopf 29 entgegen der Kraft der Ventilfeder 21 auf die Druckplatte 19 ein, wobei der Aktor 2 in der in Fig. 1 dargestellten Ausgangsstellung durch die Ventilfeder 21 vorgespannt ist.

Der piezoelektrische Aktor 2 weist eine Vielzahl von keramischen Schichten 30 und eine Vielzahl von zwischen den keramischen Schichten angeordneten Elektrodenschichten 31, 32 auf. Die Elektrodenschichten 31, 32 unterteilen sich in einen ersten Teil und einen zweiten Teil. Die Elektrodenschichten 31 des ersten Teils können die positiven Elektroden des Aktors 2 bilden und die Elektrodenschichten 32 des zweiten Teils können die negativen Elektroden des Aktors 2 bilden. Die elektrische Leitung 27 ist mit einer ersten Elektrodenanbindung 33 verbunden. Dadurch ist die elektrische Leitung 27 über die erste Elektrodenanbindung 33 mit den als negative Elektroden dienenden Elektrodenschichten 32 elektrisch verbunden. Über die elektrische Leitung 27 können die Elektrodenschichten 32 mit Masse (0 V) verbunden werden.

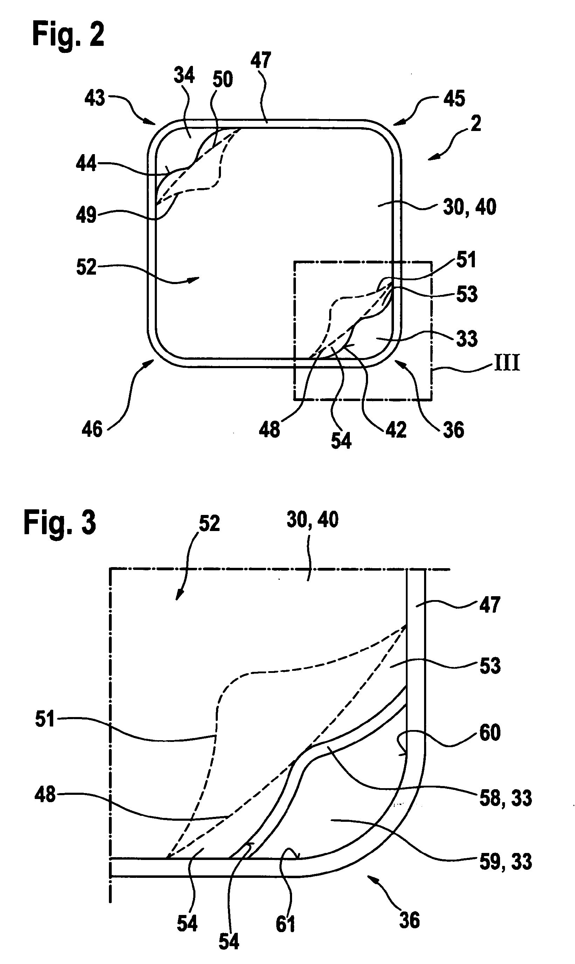

Die Elektrodenschichten 31 sind mit einer zweiten Elektrodenanbindung 34, die in der Fig. 2 dargestellt ist, verbunden. Die zweite Elektrodenanbindung 34 ist außerdem mit der elektrischen Leitung 26 verbunden. Über die elektrische Leitung 26 und die zweite Elektrodenanbindung 34 kann eine Betätigungsspannung an die als positive Elektroden dienenden Elektrodenschichten 31 angelegt werden, um den Aktor 2 zu laden.

Die Elektrodenschichten 31, 32 sind abwechselnd zwischen den keramischen Schichten 30 angeordnet. In der Fig. 1 ist der piezoelektrische Aktor 2 vereinfacht dargestellt. Die Anzahl der keramischen Schichten 30 und die Anzahl der Elektrodenschichten 31, 32 kann erheblich größer sein und es können insbesondere einige hundert aufeinander gestapelte Schichten vorgesehen sein.

Beim Anlegen einer Spannung zwischen den elektrischen Leitungen 26, 27 wird der Aktor 2 geladen, wobei sich dieser ausdehnt und den Ventilschließkörper 17 entgegen der Kraft der Ventilfeder 21 betätigt. Dadurch wird der zwischen der Ventilsitzfläche 16 und dem Ventilschließkörper 17 gebildete Dichtsitz geöffnet, so dass Brennstoff aus dem Brennstoffraum 7 über den Ringspalt 35 und den geöffneten Dichtsitz in einen Brennraum einer Brennkraftmaschine eingespritzt wird. Nach der Betätigung des Aktors 2 wird der Aktor 2 entladen, wobei sich dieser zusammenzieht und auf Grund der Schließkraft der Ventilfeder 21 eine Rückstellung des Ventilschließkörpers 17 in die in der Fig. 1 dargestellte Ausgangslage erfolgt. Der Dichtsitz zwischen der Ventilsitzfläche 16 und dem Ventilschließkörper 17 ist dann wieder geschlossen.

Die erste Elektrodenanbindung 33 ist im Bereich einer Kante 36 des Aktors 2 vorgesehen. Die Kante 36 erstreckt sich in einer Längsrichtung 37 des Aktors 2. Die Längsrichtung 37 stimmt dabei mit dem Verlauf der Achse 20 des Aktors 2 des Brennstoffeinspritzventils 1 überein. Die erste Elektrodenanbindung 33 erstreckt sich in der Längsrichtung 37 über die gesamte Kante 36 des Aktors 2. Die Elektrodenanbindung 33 kann sich aber auch nur über einen Teil der Kante 36 des Aktors 2 erstrecken. Der Aufbau des piezoelektrischen Aktors 2 ist anhand der Fig. 2 und 3 im weiteren Detail beschrieben.

Fig. 2 zeigt einen schematischen Schnitt durch den in Fig. 1 gezeigten piezoelektrischen Aktor 2 entlang der mit II bezeichneten Schnittlinie. Weitere Elemente des Brennstoffeinspritzventils 1 sind zur Vereinfachung der Darstellung nicht dargestellt.

Der Aktor 2 weist einen Aktorkörper 40 auf, der im Wesentlichen durch die keramischen Schichten 30 und die Elektrodenschichten 31, 32 gebildet ist. Im Bereich der Kante 36 weist der Aktorkörper 40 eine Aussparung 42 auf, die sich in der Längsrichtung 37 entlang der Kante 36 des Aktors 2 erstreckt. Die erste Elektrodenanbindung 33 ist in der Aussparung 42 angeordnet und bildet dabei zumindest einen Teil der Kante 36 des Aktors 2 aus. Ferner ist im Bereich einer weiteren Kante 43 des Aktors 2 eine weitere Aussparung 44 ausgebildet, die sich entlang der weiteren Kante 43 in der Längsrichtung 37 erstreckt. In der weiteren Aussparung 44 ist die zweite Elektrodenanbindung 34 angeordnet, die zumindest einen Teil der weiteren Kante 43 des Aktors 2 ausbildet.

Ferner weist der Aktor 2 weitere Kanten 45, 46 auf, die im Wesentlichen aus den keramischen Schichten 30 gebildet sind. Die keramischen Schichten 30 und die Elektrodenschichten 31, 32 sind im Bereich der weiteren Kanten 45, 46 abgerundet ausgestaltet, wodurch die weiteren Kanten 45, 46 abgerundet ausgeführt sind. Der Aktorkörper 40 und die Elektrodenanbindungen 33, 34 sind umfänglich mit einem Isolationsmittel 47 umgeben, um den Aktorkörper 40 und die Elektrodenanbindungen 33, 34 gegen die Umgebung, insbesondere den im Aktorraum 5 vorgesehenen Brennstoff, zu isolieren und zu schützen. Das Isolationsmittel 47 kann beispielsweise durch eine isolierende Beschichtung, einen Elastomermantel oder einen Schrumpf- oder Dehnschlauch gebildet sein. Durch die abgerundete Ausgestaltung der weiteren Kanten 45, 46 wird ein Anliegen des Isolationsmittels 47 beziehungsweise eine gleichmäßige Beschichtung mit dem Isolationsmittel 47 erreicht. Im Bereich der Kanten 36, 43 ist ein besonders vorteilhafter Kontakt mit dem Isolationsmittel 47 gegeben. Dies ist mit Bezugnahme auf die Fig. 3 im weiteren Detail beschrieben.

Um die Elektrodenschichten 31, 32 jeweils entweder mit der ersten Elektrodenanbindung 33 oder der zweiten Elektrodenanbindung 34 elektrisch zu kontaktieren, sind die Elektrodenschichten 32 des ersten Teils der Elektrodenschichten unterschiedlich zu den Elektrodenschichten 31 des zweiten Teils der Elektrodenschichten ausgestaltet. Im Bereich der Kante 36 sind die Elektrodenschichten 32 des ersten Teils der Elektrodenschichten 31, 32 an die Aussparung 42 herangeführt, wie es durch die unterbrochen dargestellte Begrenzungslinie 48 verdeutlicht ist. Dabei besteht zumindest abschnittsweise ein Kontakt mit der ersten Elektrodenanbindung 33. Im Bereich der weiteren Kante 43 sind die Elektrodenschichten 32 des ersten Teils der Elektrodenschichten 31, 32 beabstandet zu der weiteren Aussparung 44 ausgestaltet, wie es durch die unterbrochen dargestellte Begrenzungslinie 49 veranschaulicht ist. Dadurch wird ein Kontakt der Elektrodenschichten 32 mit der zweiten Elektrodenanbindung 34 verhindert. Entsprechend sind die Elektrodenschichten 31 des zweiten Teils der Elektrodenschichten 31, 32 im Bereich der weiteren Kante 43 an die weitere Aussparung 44 herangeführt, wie es durch die unterbrochen dargestellte Begrenzungslinie 50 veranschaulicht ist, so dass die Elektrodenschichten 31 mit der zweiten Elektrodenanbindung 34 elektrisch verbunden sind. Ferner sind die Elektrodenschichten 31 im Bereich der Kante 36 beabstandet zu der Aussparung 42 ausgestaltet, wie es durch die Begrenzungslinie 51 veranschaulicht ist, so dass ein Kontakt zwischen der ersten Elektrodenanbindung 33 und den Elektrodenschichten 31 verhindert ist. In einem Innenbereich 52 des Aktorkörpers 40 sind sowohl die Elektrodenschichten 31 als auch die Elektrodenschichten 32 ausgebildet, um eine möglichst große wirksame Querschnittsfläche zur Betätigung des Aktors 2 zu erzielen. Allerdings kann in Randbereichen 53, 54, die an die Aussparung 42 angrenzen, keine der Elektrodenschichten 31, 32 vorgesehen sein. Diese Randbereiche 53, 54 sind aber vorzugsweise von geringer Querschnittsfläche und können auch entfallen.

Fig. 3 zeigt den in Fig. 2 mit III bezeichneten Ausschnitt des piezoelektrischen Aktors 2 im Detail.

Bei der Herstellung des Aktors 2 wird vor der Sinterung und vor der Entbinderung die Aussparung 42 des Aktorkörpers 40 ausgeformt. Die Aussparung 42 kann durch eine Nut, eine Einprägung oder dergleichen ausgestaltet sein. Die Aussparung 42 wird vorzugsweise vor dem Sintern und Entbindern in einem Druckschritt bedruckt, um eine Kontaktschicht 58 im Bereich der Kante 36 auf den Aktorkörper 40 aufzubringen, die sich entlang der gesamten Kante 36 in Längsrichtung 37 erstreckt. Die Kontaktschicht 58 wird zusammen mit dem Aktorkörper 40 entbindert und gesintert. In die mit der Kontaktschicht 58 versehene Aussparung 42 wird dann ein Leitmittel 59 eingebracht, um die Kante 36 des Aktors 2 auszuformen und um die gegebenenfalls gesiebt ausgebildeten Elemente der Kontaktschicht 58 zuverlässig miteinander zu kontaktieren. Dadurch wird auch bei einer Betätigung des Aktors 2, bei der sich dieser in Längsrichtung 37 ausdehnt, der elektrische Kontakt zwischen den Elektroden 32 aufrechterhalten. Ferner dient das Leitmittel 59 zum Verbinden der Elektrodenschichten 32 mit der elektrischen Leitung 27. Das Leitmittel 59 kann aus einem elektrisch leitenden Klebstoff gebildet sein. Die Kontaktschicht 58 und das mit der Kontaktschicht 58 verbundene Leitmittel 59 bilden zusammen die erste Elektrodenanbindung 33 aus. Entsprechend ist auch die zweite Elektrodenanbindung 34 aus einer Kontaktschicht und einem Leitmittel ausgestaltet.

Das Leitmittel 59 ermöglicht die Ausbildung der Kante 36 ohne scharfe Kanten oder scharfe Vorsprünge, so dass das Isolationsmittel 47 speziell in Übergangsbereichen 60, 61, in denen ein Übergang von dem Aktorkörper 40 in die abgerundete Kante 36 erfolgt, sowohl an dem Aktorkörper 40 als auch an der ersten Elektrodenanbindung 33 spaltfrei anliegt und eine Beschädigung des Isolationsmittels 47 oder ein Abreiben des Isolationsmittels 47 während der Betätigung des Aktors 2 verhindert ist. Entsprechende Vorteile ergeben sich auch im Bereich der weiteren Kante 43.

## Patentansprüche

1. Piezoelektrischer Aktor (2), insbesondere Aktor für Brennstoffeinspritzventile, mit einem Aktorkörper (40), der eine Vielzahl von keramischen Schichten (30) und eine Vielzahl von zwischen den keramischen Schichten (30) angeordneten Elektrodenschichten (31, 32) aufweist, und zumindest einer ersten Elektrodenanbindung (33), die mit einem ersten Teil der Elektrodenschichten (31, 32) des Aktorkörpers (40) elektrisch verbunden ist, wobei
der Aktorkörper (40) zumindest eine Aussparung (42) aufweist, die im Bereich einer in einer Längsrichtung (37) des Aktors (2) verlaufenden Kante (36) des Aktors (2) vorgesehen ist, sich die Aussparung (42) in der Längsrichtung (37) erstreckt und die erste Elektrodenanbindung (33) in der Aussparung (42) angeordnet ist und zumindest teilweise die Kante (36) des Aktors (2) ausbildet, wobei
die erste Elektrodenanbindung (33) eine Kontaktschicht (58) aufweist, die im Bereich der Kante (36) des Aktors (2) mit dem Aktorkörper (40) mechanisch verbunden ist und mit dem ersten Teil der Elektrodenschichten (31, 32) zumindest abschnittsweise elektrisch und mechanisch verbunden ist,
**dadurch gekennzeichnet,**
**dass** die Kontaktschicht (58) vor einem Sinterprozess zur Herstellung des Aktors (2) im Bereich der Kante (36) des Aktors (2) auf den Aktorkörper (40) aufgedruckt und mit dem Aktorkörper (40) durch Sintern verbunden ist.

2. Piezoelektrischer Aktor nach Anspruch 1,
**dadurch gekennzeichent,**
dass der erste Teil der Elektrodenschichten (31, 32) im Bereich der Kante (36) des Aktors (2) zumindest abschnittsweise an die Aussparung (42) des Aktorkörpers (40) angrenzt.

3. Piezoelektrischer Aktor nach Anspruch 2,
**dadurch gekennzeichnet,**
**dass** ein zweiter Teil der Elektrodenschichten (31, 32) im Bereich der Kante (36) des Aktors (2) beabstandet zu der Aussparung (42) ausgebildet ist.

4. Piezoelektrischer Aktor nach einem der Ansprüche 1 bis 3,
**dadurch gekennzeichnet,**
**dass** die erste Elektrodenanbindung (33) ein Leitmittel (59) aufweist, das zumindest mittelbar mit dem ersten Teil der Elektrodenschichten (31, 32) verbunden ist, und dass das Leitmittel (59) zumindest im Wesentlichen die Kante (36) des Aktors (2) ausbildet.

5. Piezoelektrischer Aktor nach Anspruch 4,
**dadurch gekennzeichnet,**
**dass** das Leitmittel (59) aus einem elektrisch leitenden Klebstoff gebildet ist.

6. Piezoelektrischer Aktor nach einem der Ansprüche 1 bis 5,
**dadurch gekennzeichnet,**
**dass** eine zweite Elektrodenanbindung (34) vorgesehen ist, die mit einem zweiten Teil der Elektrodenschichten (31, 32) des Aktorkörpers (40) elektrisch verbunden ist, dass der Aktorkörper (40) eine weitere Aussparung (44) aufweist, die im Bereich einer in der Längsrichtung (37) des Aktors (2) verlaufenden weiteren Kante (43) des Aktors (2) vorgesehen ist, dass sich die weitere Aussparung (44) in der Längsrichtung (37) erstreckt und dass die zweite Elektrodenanbindung (34) in der weiteren Aussparung (44) angeordnet ist und zumindest teilweise die weitere Kante (43) des Aktors (2) ausbildet.

7. Piezoelektrischer Aktor nach Anspruch 6,
**dadurch gekennzeichnet,**
**dass** der zweite Teil der Elektrodenschichten (31, 32) im Bereich der weiteren Kante (43) des Aktors (2) zumindest abschnittsweise an die weitere Aussparung (44) des Aktorkörpers (40) angrenzt und dass der erste Teil der Elektrodenschichten (31, 32) im Bereich der weiteren Kante (43) des Aktors (2) beabstandet zu der Aussparung (44) ausgebildet ist.

8. Piezoelektrischer Aktor nach einem der Ansprüche 3, 6 oder 7,
**dadurch gekennzeichnet,**
**dass** die Elektrodenschichten (32) des ersten Teils der Elektrodenschichten (31, 32) abwechselnd mit den Elektrodenschichten (31) des zweiten Teils der Elektrodenschichten (31, 32) zwischen den keramischen Schichten (30) des Aktorkörpers (40) vorgesehen sind.

9. Piezoelektrischer Aktor nach einem der Ansprüche 1 bis 8,
**dadurch gekennzeichent,**
dass zum elektrischen Isolieren des Aktorkörpers (40) und zumindest der ersten Elektrodenanbindung (33) ein Isolationsmittel (47) vorgesehen ist, das den Aktorkörper (40) und zumindest die erste Elektrodenanbindung (33) umfänglich umschließt.

10. Brennstoffeinspritzventil (1), insbesondere Injektor für Brennstoffeinspritzanlagen von luftverdichtenden, selbstzündenden Brennkraftmaschinen, mit einem Aktor (2) nach einem der Ansprüche 1 bis 9 und einem von dem Aktor (2) betätigbaren Ventilschließkörper (17), der mit einer Ventilsitzfläche (16) zu einem Dichtsitz zusammenwirkt.

## Claims

1. Piezoelectric actuator (2), in particular an actuator for fuel injection valves, comprising an actuator body (40), which has a multiplicity of ceramic layers (30) and a multiplicity of electrode layers (31, 32) arranged between the ceramic layers (30), and at least one first electrode connection (33), which is electrically connected to a first part of the electrode layers (31, 32) of the actuator body (40), wherein the actuator body (40) has at least one recess (42), which is provided in the region of an edge (36) of the actuator (2) running in a longitudinal direction (37) of the actuator (2), the recess (42) extends in the longitudinal direction (37) and the first electrode connection (33) is arranged in the recess (42) and at least partially forms the edge (36) of the actuator (2), wherein the first electrode connection (33) has a contact layer (58), which in the region of the edge (36) of the actuator (2) is mechanically connected to the actuator body (40) and electrically and mechanically connected at least in certain portions to the first part of the electrode layers (31, 32), **characterized in that** the contact layer (58) is pressed onto the actuator body (40) in the region of the edge (36) of the actuator before a sintering process for producing the actuator (2) and is connected to the actuator body (40) by sintering.

2. Piezoelectric actuator according to Claim 1, **characterized in that**, in the region of the edge (36) of the actuator (2), the first part of the electrode layers (31, 32) at least in certain portions adjoins the recess (42) of the actuator body (40).

3. Piezoelectric actuator according to Claim 2, **characterized in that**, in the region of the edge (36) of the actuator (2), a second part of the electrode layers (31, 32) is formed at a distance from the recess (42).

4. Piezoelectric actuator according to one of Claims 1 to 3, **characterized in that** the first electrode connection (33) has a conducting means (59), which is at least indirectly connected to the first part of the electrode layers (31, 32), and **in that** the conducting means (59) at least substantially forms the edge (36) of the actuator (2).

5. Piezoelectric actuator according to Claim 4, **characterized in that** the conducting means (59) is formed from an electrically conducting adhesive.

6. Piezoelectric actuator according to one of Claims 1 to 5, **characterized in that** a second electrode connection (34) is provided and is electrically connected to the second part of the electrode layers (31, 32) of the actuator body (40), **in that** the actuator body (40) has a further recess (44), which is provided in the region of a further edge (43) of the actuator (2), running in the longitudinal direction (37) of the actuator (2), **in that** the further recess (44) extends in the longitudinal direction (37) and **in that** the second electrode connection (34) is arranged in the further recess (44) and at least partially forms the further edge (43) of the actuator (2).

7. Piezoelectric actuator according to Claim 6, **characterized in that**, in the region of the further edge (43) of the actuator (2), the second part of the electrode layers (31, 32) adjoins at least in certain portions the further recess (44) of the actuator body (40) and **in that**, in the region of the further edge (43) of the actuator (2), the first part of the electrode layers (31, 32) is formed at a distance from the recess (44).

8. Piezoelectric actuator according to one of Claims 3, 6 or 7, **characterized in that** the electrode layers (32) of the first part of the electrode layers (31, 32) are provided in alternation with the electrode layers (31) of the second part of the electrode layers (31, 32) between the ceramic layers (30) of the actuator body (40).

9. Piezoelectric actuator according to one of Claims 1 to 8, **characterized in that**, for the electrical insulation of the actuator body (40) and at least the first electrode connection (33), an insulating means (47) is provided and circumferentially encloses the actuator body (40) and at least the first electrode connection (33).

10. Fuel injection valve (1), in particular an injector for fuel injection systems of self-igniting air-compression internal combustion engines, comprising an actuator (2) according to one of Claims 1 to 9 and a valve closing body (17), which can be actuated by the actuator (2) and interacts with a valve seating face (16) to form a sealing seat.

## Revendications

1. Actionneur piézoélectrique (2), en particulier actionneur pour soupape d'injection de carburant, l'actionneur présentant un corps d'actionneur (40) qui présente plusieurs couches céramiques (30) et plusieurs couches d'électrodes (31, 32) disposées entre les couches céramiques (30) et au moins une première liaison d'électrode (33) reliée électriquement à une première partie des couches d'électrode (31, 32) du corps d'actionneur (40),
le corps d'actionneur (40) présentant au moins une découpe (42) prévue au niveau d'un coin (36) de l'actionneur (32) qui s'étend dans le sens de la longueur (37) de l'actionneur (2), la découpe (42) s'étendant dans le sens de la longueur (37) et la première liaison d'électrode (33) étant disposée dans la découpe (42) et formant au moins une partie du coin (36) de l'actionneur (2),
la première liaison d'électrode (33) présentant une couche de contact (58) reliée mécaniquement au corps d'actionneur (40) au niveau du coin (36) de l'actionneur (2) et étant reliée électriquement et mécaniquement au moins en partie à la première partie des couches d'électrode (31, 32),
**caractérisé en ce que**
la couche de contact (58) est imprimée sur le corps d'actionneur (40) au niveau du coin (36) de l'actionneur (2) avant une opération de frittage de fabrication de l'actionneur (2) et est reliée au corps d'actionneur (40) par frittage.

2. Actionneur piézoélectrique selon la revendication 1, **caractérisé en ce que** la première partie des couches d'électrode (31, 32) est au moins partiellement adjacente à la découpe (42) du corps d'actionneur (40) au niveau du coin (36) de l'actionneur (2).

3. Actionneur piézoélectrique selon la revendication 2, **caractérisé en ce qu'**une deuxième partie des couches d'électrode (31, 32) est formée à distance de la découpe (42) au niveau du coin (36) de l'actionneur (2).

4. Actionneur piézoélectrique selon l'une des revendications 1 à 3, **caractérisé en ce que** la première liaison d'électrode (33) présente un moyen conducteur (59) qui est relié au moins indirectement à la première partie des couches d'électrode (31, 32) et **en ce que** le moyen conducteur (59) forme au moins essentiellement le coin (36) de l'actionneur (2).

5. Actionneur piézoélectrique selon la revendication 4, **caractérisé en ce que** le moyen conducteur (59) est formé d'un adhésif électriquement conducteur.

6. Actionneur piézoélectrique selon l'une des revendications 1 à 5, **caractérisé en ce qu'**une deuxième liaison d'électrode (34) est prévue et est reliée électriquement à une deuxième partie des couches d'électrode (31, 32) du corps d'actionneur (40), **en ce que** le corps d'actionneur (40) présente une autre découpe (44) au niveau d'un autre coin (43) de l'actionneur (2) qui s'étend dans le sens de la longueur (37) de l'actionneur (2), **en ce que** l'autre découpe (44) s'étend dans le sens de la longueur (37) et **en ce que** la deuxième liaison d'électrode (34) est disposée dans l'autre découpe (44) et forme au moins une partie de l'autre coin (43) de l'actionneur (2).

7. Actionneur piézoélectrique selon la revendication 6, **caractérisé en ce que** la deuxième partie des couches d'électrode (31, 32) est au moins partiellement adjacente à l'autre découpe (44) du corps d'actionneur (40) au niveau de l'autre coin (43) de l'actionneur (2) et **en ce que** la première partie des couches d'électrode (31, 32) est formée à distance de la découpe (44) au niveau de l'autre coin (43) de l'actionneur (2).

8. Actionneur piézoélectrique selon l'une des revendications 3, 6 ou 7, **caractérisé en ce que** les couches d'électrode (32) de la première partie des couches d'électrode (31, 32) sont prévues en alternance avec les couches d'électrode (31) de la deuxième partie des couches d'électrode (31, 32) entre les couches céramiques (30) du corps d'actionneur (40).

9. Actionneur piézoélectrique selon l'une des revendications 1 à 8, **caractérisé en ce qu'**un moyen isolant (47) qui entoure la périphérie du corps d'actionneur (40) et au moins la première liaison d'électrode (33) est prévu pour isoler électriquement le corps d'actionneur (40) et au moins la première liaison d'électrode (33).

10. Soupape (1) d'injection de carburant, en particulier injecteur pour installations d'injection de carburant de moteurs à combustion interne à autoallumage et compression d'air, dotée d'un actionneur (2) selon l'une des revendications 1 à 9 et d'un corps (17) de fermeture de soupape apte à être actionné par l'actionneur (2) et coopérant avec une surface (16) de siège de soupape pour former un siège étanche.
